# EUROPÄISCHE PATENTSCHRIFT

(11) **EP 2 011 209 B1**
(45) Veröffentlichungstag und Bekanntmachung des Hinweises auf die Patenterteilung: **18.05.2011**
(21) Anmeldenummer: 07727374.6
(22) Anmeldetag: 27.03.2007
(51) Int. Cl.: H02J 7/00

(54) **ELEKTROHANDWERKZEUGMASCHINE MIT AUSSCHALTVERZÖGERUNGSVORRICHTUNG**
HANDHELD ELECTRICAL MACHINE TOOL WITH SHUT-OFF DELAY APPARATUS
OUTILLAGE À MAIN ÉLECTRIQUE AVEC DISPOSITIF DE TEMPORISATION EN COURS DE CYCLE

(30) Priorität: 11.04.2006 DE 102006017369
(43) Veröffentlichungstag der Anmeldung: 07.01.2009
(73) Patentinhaber: Robert Bosch GmbH, 70442 Stuttgart (DE)
(72) Erfinder: GLAUNING, Rainer, 72631 Aichtal-Groetzingen (DE); WIRNITZER, Bernd, 71292 Friolzheim (DE)
(86) Internationale Anmeldenummer: PCT/EP2007/052901
(87) Internationale Veröffentlichungsnummer: WO 2007/118768

(56) Entgegenhaltungen:
- WO-A-97/48577
- US-A- 5 272 380
- US-A1- 2003 137 279

## Beschreibung

Die Erfindung betrifft eine Elektrohandwerkzeugmaschine mit mindestens einem elektrischen Antrieb, mindestens einer elektrischen, für ihre Funktion elektrische Energie benötigenden Einrichtung, einer Ausschaltverzögerungsvorrichtung für den elektrischen Antrieb und/oder die elektrische Einrichtung und mit mindestens einem Akkumulator für die elektrische Versorgung des Antriebs und der elektrischen Einrichtung.

### Stand der Technik

Eine derartige Elektrohandwerkzeugmaschine ist bekannt. Dabei wird der Akkumulator bei einem Abschalten der Elektrohandwerkzeugmaschine - zum Beispiel durch Loslassen eines entsprechenden Tasterdrückers - vollständig von allen elektrischen Verbrauchern der Elektrohandwerkzeugmaschine getrennt. Dies geschieht bei dem elektrischen Antrieb des Elektrohandwerkzeugs zumeist unverzüglich, da ein Verlängern der Nachlaufzeit des vom elektrischen Antrieb angetriebenen Werkzeugs nicht erwünscht ist. Bei anderen elektrischen Einrichtungen ist jedoch eine verzögerte Abschaltung sinnvoll. Bei diesen elektrischen Einrichtungen handelt es sich zum Beispiel um zusätzliche Mess- oder Prüfeinrichtungen oder die Steuerelektronik der Elektrohandwerkzeugmaschine selbst. Während die elektrischen Komponenten, die im Betrieb einen hohen Stromverbrauch aufweisen zumeist unverzüglich abgeschaltet werden, ist bei elektrischen Einrichtungen, die kaum Strom verbrauchen (wie zum Beispiel der Steuerelektronik) eine verzögerte Abschaltung möglich und sinnvoll. Da die Steuerelektronik eine kurze Zeitspanne benötigt um vollständig betriebsbereit zu sein, kommt es bei einem Wiederanschalten der Elektrohandwerkzeugmaschine mit abgeschalteter Steuerelektronik zu einer kurzen Totzeit, bis diese auf die Schaltanfrage durch den Bediener reagiert. Dies ist bedienerunfreundlich und kann insbesondere bei handgeführten Elektrowerkzeugen zu Fehlfunktionen führen, da der elektrische Antrieb zu einem späteren Zeitpunkt startet als der Bediener erwartet. Durch die verzögerte Abschaltung der Steuerelektronik kann bei Wiederinbetriebnahme innerhalb der Verzögerungszeit ein Auftreten von Totzeiten vermieden werden. Da elektrische Einrichtungen für ihre Funktion -wenn auch nur wenig - elektrische Energie benötigen, kann dies bei akkumulatorbetriebenen Elektrohandwerkzeugmaschinen zu einer Entladung des Akkumulators führen. Wird dadurch ein Tiefentladungsbereich des Akkumulators erreicht, so kann dies den Akkumulator schädigen.

Eine Elektrohandwerkzeugmaschine ist z.B aus US 2003/137279 A1 inklusive Tiefentladungsschutz bekannt.

### Technische Aufgabe

Trotz verzögerter Abschaltung mindestens einer elektrischen Einrichtung soll eine Tiefentladung des Akkumulators verhindert werden.

### Technische Lösung

Zur Lösung dieser Aufgabe ist vorgesehen, dass die Elektrohandwerkzeugmaschine eine Tiefentladungsschutzvorrichtung aufweist, die in Abhängigkeit von dem durch sie erfassten Ladezustand des Akkumulators die Verzögerungszeit der Ausschaltverzögerungsvorrichtung vorgibt. Durch eine derartige Tiefentladungsschutzvorrichtung wird die Zeitspanne einer elektrischen Energieentnahme aus dem Akkumulator durch den Ladezustand des Akkumulators selbst begrenzt. Ein weiteres Entladen des Akkumulators durch die elektrische Einrichtung ist somit nur noch in einer Größenordnung gestattet, die selbst vom Ladezustand des Akkumulators abhängt.

### Vorteilhafte Wirkungen

Nach einer Weiterbildung der Erfindung ist vorgesehen, dass die Ausschaltverzögerungsvorrichtung die Tiefentladungsschutzvorrichtung aufweist. Dies verringert die Anzahl der benötigten Bauelemente.

Insbesondere ist vorgesehen, dass die Tiefentladungsschutzvorrichtung bei geringerem Ladezustand des Akkumulators eine geringere Verzögerungszeit der Ausschaltverzögerungsvorrichtung vorgibt. Je geringer der Ladezustand ist, desto weniger Energie darf dem Akkumulator entnommen werden um nicht in einen für den Akkumulator schädlichen Tiefentladungsbereich zu gelangen.

Weiterhin ist vorgesehen, dass die Ausschaltverzögerungsvorrichtung bei einem Ladezustand des Akkumulators unterhalb einer kritischen Ladungsschwelle keine Ausschaltverzögerung vorsieht. Ist der Ladezustand des Akkumulators unter eine kritischen Ladungsschwelle abgesunken, so wird auch die elektrische Einrichtung ohne Zeitverzögerung abgeschaltet. Ein weiteres Entladen des Akkumulators wird durch diese Maßnahme unterbunden.

Die Erfindung betrifft ferner ein Verfahren zum Betrieb einer Elektrohandwerkzeugmaschine mit mindestens einem elektrischen Antrieb, mindestens einer elektrischen, für ihre Funktion elektrische Energie benötigenden Einrichtung, einer Ausschaltverzögerungsvorrichtung für den elektrischen Antrieb und/oder die elektrische Einrichtung und mit mindestens einem Akkumulator für die elektrische Versorgung des elektrischen Antriebs und der elektrischen Einrichtung. Dabei ist vorgesehen, dass eine Tiefentladungsschutzvorrichtung der Elektrohandwerkzeugmaschine den Ladezustand des Akkumulators erfasst und in Abhängigkeit von diesem Ladezustand eine Verzögerungszeit vorgibt, mit der die elektrische Einrichtung durch die Ausschaltverzögerungsvorrichtung verzögert abgeschaltet wird. Durch ein derartiges Verfahren wird die Zeitspanne einer elektrischen Energieentnahme aus dem Akkumulator durch den Ladezustand des Akkumulators selbst begrenzt.

Nach einer Weiterbildung der Erfindung ist vorgesehen, dass die Tiefentladungsschutzvorrichtung bei geringerem Ladezustand des Akkumulators eine geringere Verzögerungszeit der Ausschaltverzögerungsvorrichtung vorgibt. Durch die geringere Verzögerungszeit entnimmt die elektrische Einrichtung dem Akkumulator über einen kürzeren Zeitraum elektrische Energie, sodass dieser weniger weit entladen wird.

Weiterhin ist vorgesehen, dass die Ausschaltverzögerungsvorrichtung die elektrische Einrichtung bei einem Ladezustand des Akkumulators unterhalb einer kritischen Ladungsschwelle ohne Ausschaltverzögerung abschaltet. Dabei kann entweder die Tiefentladungsschutzvorrichtung eine Verzögerungszeit gleich Null Sekunden vorgeben oder die Ausschaltverzögerungsvorrichtung selbst ohne Verzögerung ausschalten.

Insbesondere ist vorgesehen, dass die Verzögerungszeit nur vorbestimmte Werte annehmen kann. Diese Werte können zum Beispiel ganzzahlige Vielfache von einem vorgegebenen Zeitintervall sein.

Nach einer Weiterbildung der Erfindung ist vorgesehen, dass die Tiefentladungsschutzvorrichtung die Verzögerungszeit mit dem Ladezustand des Akkumulators bis zum Erreichen der kritischen Ladungsschwelle kontinuierlich geändert vorgibt. Bei einer kontinuierlich geänderten Vorgabe der Verzögerungszeit kann die Ausschaltverzögerungsvorrichtung die Ausschaltverzögerung kontinuierlich an den Ladezustand anpassen.

Alternativ ist vorgesehen, dass die Tiefentladungsschutzvorrichtung die Verzögerungszeit mit dem Ladezustand des Akkumulators schrittweise geändert vorgibt.

Nach einer Weiterbildung der Erfindung ist vorgesehen, dass die Tiefentladungsschutzvorrichtung den Ladezustand des Akkumulators durch Ermittlung der Akkumulatorspannung bestimmt. Die Akkumulatorspannung ist eine Größe, die sich bei entladenem oder teilentladenem Akkumulator deutlich mit dem Ladezustand ändert. Die Akkumulatorspannung lässt in diesem Ladungsbereich eindeutige Rückschlüsse auf den Ladezustand des Akkumulators zu. Basiert der Akkumulator auf Lithiumionen-Zellen, so fällt die Akkumulatorspannung mit abnehmendem Ladezustand immer steiler ab. Bei einem sehr weit entladenem Akkumulator dieser Art ist schon bei geringer Stromentnahme - zum Beispiel durch die elektrische Einrichtung - ein extremes Absinken der Akkumulatorspannung zu beobachten.

Nach einer Weiterbildung der Erfindung ist vorgesehen, dass die Akkumulatorspannung zusammen mit einem entsprechenden Strom bei elektrischer Belastung gemessen wird. Wird die Akkumulatorspannung während des Betriebs kontinuierlich oder in zeitlichen Abständen ermittelt, so wird sie durch elektrische Verbraucher wie zum Beispiel dem elektrischen Antrieb belastet. Um Rückschlüsse auf den Ladezustand des Akkumulators zu gewinnen, muss die Akkumulatorspannung zusammen mit dem entsprechenden Strom gemessen werden. Diese Messung lässt bei Kenntnis der Kennlinie des Akkumulators Rückschlüsse auf die Akkumulatorleerlaufspannung beziehungsweise den Ladezustand zu.

Alternativ oder zusätzlich ist vorgesehen, dass die Akkumulatorspannung quasi-stromfrei gemessen wird. Wird die Akkumulatorspannung zum Beispiel nach dem Abschalten des elektrischen Antriebs und aller anderen Bauteile mit hoher Leistungsaufnahme gemessen, so ergibt sich eine quasi-stromfreie Messung der Akkumulatorleerlaufspannung.

Nach einer Weiterbildung der Erfindung ist vorgesehen, dass die Tiefentladungsschutzvorrichtung ein Einschalten des elektrischen Antriebs nur bei einem Ladezustand des Akkumulators oberhalb einer Antriebs-Einschaltladungsschwelle ermöglicht. Dazu ist die Antriebs-Einschaltladungsschwelle so gewählt, dass der Ladezustand des Akkumulators den Betrieb der Elektrohandwerkzeugmaschine über einen gewissen, der Anwendung des Elektrohandwerkzeugs entsprechenden Zeitraum gewährleisten kann.

Zusätzlich ist vorgesehen, dass die Tiefentladungsschutzvorrichtung ein Einschalten der elektrischen Einrichtung nur bei einem Ladezustand des Akkumulators oberhalb einer Einrichtungs-Einschaltladungsschwelle ermöglicht. Diese Maßnahme verhindert ein weiteres Entladen des Akkumulators durch Wiedereinschalten der elektrischen Einrichtung. Die Einrichtungs-Einschaltladungsschwelle ist insbesondere deutlich geringer als die Antriebs-Einschaltladungsschwelle, da der elektrische Verbrauch der elektrischen Einrichtung geringer ist als der des elektrischen Antriebs.

### Kurze Beschreibung der Zeichnungen

Die Zeichnungen veranschaulichen die Erfindung anhand eines Ausführungsbeispiels, und zwar zeigt:
- Figur 1: eine schematische Darstellung einer Elektrohandwerkzeugmaschine mit Ausschaltverzögerungsvorrichtung und
- Figur 2: ein Diagramm mit möglichen Abhängigkeiten der Verzögerungszeit von der Akkumulatorspannung.

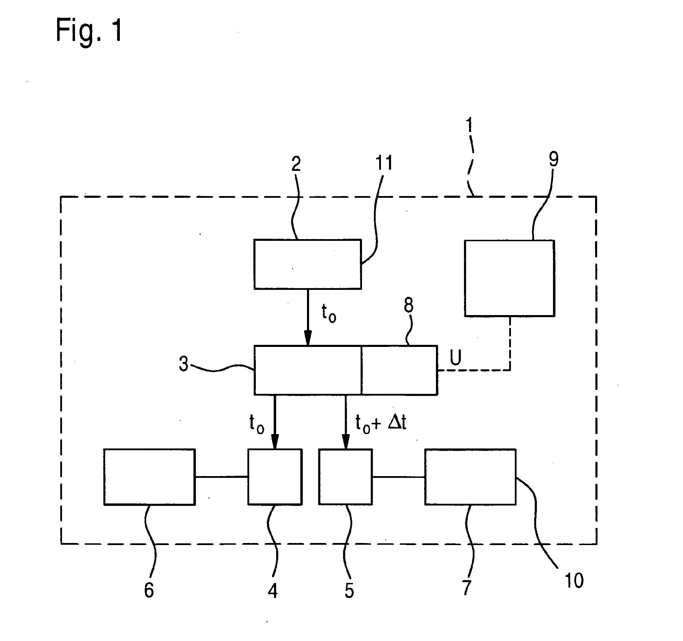

In Figur 1 ist der prinzipielle Aufbau einer akkumulatorbetriebenen Elektrohandwerkzeugmaschine 1 gezeigt. Die Darstellung ist dabei auf wesentliche Komponenten zum An- und Abschalten der Elektrohandwerkzeugmaschine 1 reduziert. Ein Bedienelement 2 ist mit einer Ausschaltverzögerungsvorrichtung 3 wirkverbunden, die über Schalteinrichtungen 4, 5 auf einen elektrischen Antrieb 6 und eine elektrische Einrichtung 7 der Elektrohandwerkzeugmaschine 1 wirken. Die elektrische Schalteinrichtung 4 ist dem elektrischen Antrieb 6 zugeordnet und die Schalteinrichtung 5 ist der elektrische Einrichtung 7 zugeordnet. Die Elektrohandwerkzeugmaschine 1 weist weiterhin eine Tiefentladungsschutzvorrichtung 8 auf, die in diesem Ausführungsbeispiel Teil der Ausschaltverzögerungsvorrichtung 3 ist. Die elektrischen Komponenten der Elektrohandwerkzeugmaschine 1, insbesondere die elektrische Einrichtung 7 und der elektrische Antrieb 6, werden von einem Akkumulator 9 elektrisch versorgt. Entsprechende Versorgungsleitungen sind nicht dargestellt. Bei der elektrischen Einrichtung 7 handelt es sich zum Beispiel um eine Steuerelektronik 10 der Elektrohandwerkzeugmaschine 1. Das Bedienelement 2 kann zum Beispiel als Tasterdrücker 11 eines Tast-/Rastschalters ausgebildet sein. Die Schalteinrichtungen 4, 5 können auch Teil der Ausschaltverzögerungsvorrichtung 3 sein. Alternativ kann eine der Schalteinrichtungen 4, 5 auch direkt mit dem Bedienelement wirkverbunden sein. Dies ist häufig bei der dem elektrischen Antrieb 6 zugeordnete Schalteinrichtungen 4 der Fall, damit sichergestellt ist, dass der Antrieb (und damit das Werkzeug) möglichst unverzüglich stoppt.

Es ergibt sich folgende Funktion der Elektrohandwerkzeugmaschine 1 mit Ausschaltverzögerungsvorrichtung 3: Betätigt ein Bediener das Bedienelement 2, um im Betrieb die Elektrohandwerkzeugmaschine 1 abzuschalten, so gibt das Bedienelement 2 der Ausschaltverzögerungsvorrichtung 3 einen Ausschaltzeitpunkt t₀ zum Ausschalten der Elektrohandwerkzeugmaschine 1 vor. Durch eine nicht dargestellte Ermittlungsvorrichtung wird der Ladezustand des Akkumulators 9 bestimmt und der Tiefentladungsschutzvorrichtung 8 ein entsprechendes Signal zugeführt. Die Tiefentladungsschutzvorrichtung 8 gibt in Abhängigkeit von dem Ladezustand des Akkumulators 9 der Ausschaltverzögerungsvorrichtung 3 eine Verzögerungszeit Δt für ein verzögertes Abschalten der elektrischen Einrichtung 7 vor. Für das Abschalten des elektrischen Antriebs 6 ist in diesem Ausführungsbeispiel keine Verzögerungszeit Δt vorgesehen, sodass die Ausschaltverzögerungsvorrichtung 3 den elektrischen Antrieb 6 zum Zeitpunkt t₀ abschaltet. Abschalten bedeutet in diesem Zusammenhang ein vollständiges Abtrennen des elektrischen Verbrauchers (hier des elektrischen Antriebs 6) vom Akkumulator 9. Zum Abschalten der elektrischen Einrichtung 7 berücksichtigt die Ausschaltverzögerungsvorrichtung 3 die von der Tiefentladungsschutzvorrichtung 8 vorgegebene Verzögerungszeit Δt, wobei sie die elektrische Einrichtung 7 zum Zeitpunkt t₀ + Δt abschaltet. Es ergibt sich nach Betätigen des Bedienelements 2 eine unverzügliche Abschaltung des elektrischen Antriebs 6 sowie eine um die Verzögerungszeit Δt verzögerte Abschaltung der elektrischen Einrichtung 7. Die Erfassung des Ladezustands des Akkumulators 9 erfolgt dazu in diesem Beispiel durch Ermittlung der Akkumulatorspannung U, die zum Beispiel gleichzeitig als Eingangswert der Tiefentladungsschutzvorrichtung 8 dienen kann.

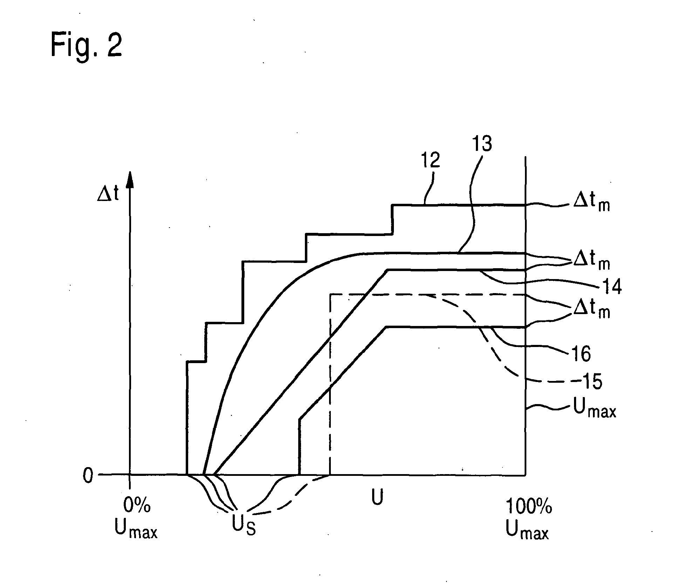

Die Figur 2 zeigt ein Diagramm, bei dem die Verzögerungszeit Δt als Ordinate über der relativen Akkumulatorspannung U/Uₘₐₓ als Abszisse aufgetragen ist. Der Wert 100% Uₘₐₓ entspricht der maximale Akkumulatorspannung bei voll aufgeladenem Akkumulator 9. Die Akkumulatorspannung U ist dabei ein Maß für den Ladezustand des Akkumulators 9. Mehrere mögliche von der Tiefentladungsschutzvorrichtung 8 gebildete Zusammenhänge zwischen der Akkumulatorspannung U und der Verzögerungszeit Δt für verschiedene Anwendungen sind beispielhaft in dem Diagramm der Figur 2 dargestellt. In dieser Darstellung sind die qualitativen Verläufe 12, 13, 14, 15, 16 (Kurvenverläufe) des von der Tiefentladungsschutzvorrichtung 8 vorgegebenen Zusammenhangs zwischen der Verzögerungszeit Δt und der Spannung U gezeigt. Die jeweiligen Spannungsschwellen Uₛ entsprechen kritischen Ladungsschwellen, bei denen die Verzögerungszeit Δt auf Null abgesunken ist und sind in einem Bereich von etwa 15 bis 50 % von Uₘₐₓ beispielhaft gezeigt. Die Spannungsschwellen Uₛ sind in Figur 2 derart niedrig und unterschiedlich gewählt, damit die qualitative Kurvenformen in den Bereichen oberhalb der Spannungsschwellen Uₛ möglichst klar erkennbar sind. Derzeit verwendete Spannungsschwellen Uₛ liegen bei höheren Werten als in Figur 2 dargestellt. Die Höhe der Schnittpunkte Δtₘ der Verläufe 12, 13, 14, 15, 16 mit der Geraden Uₘₐₓ gibt die maximale Verzögerungszeit bei entsprechendem Verlauf 12, 13, 14, 15, 16 an. Für Werte der Akkumulatorspannung U, die geringer als die jeweilige Spannungsschwelle Uₛ ist, weist jeder der Verläufe 12, 13, 14, 15, 16 eine konstante Verzögerungszeit von Δt = 0 auf. Die elektrische Einrichtung 7 wird bei allen Zusammenhängen bei einer Akkumulatorspannung U unterhalb der entsprechenden Spannungsschwelle Uₛ verzögerungsfrei abgeschaltet. Daher werden im Folgenden nur die Bereiche der Verläufe 12, 13, 14, 15, 16 betrachtet, bei denen die Akkumulatorspannungen U oberhalb der jeweiligen Spannungsschwelle Uₛ liegt.

Der stufenförmige Verlauf 12 zeigt eine sprunghafte Änderung der Verzögerungszeit Δt bei Änderung der Akkumulatorspannung U, wobei einzelnen Spannungsbereichen fest vorbestimmte Verzögerungszeitwerte zugeordnet sind. Der Verlauf 13 zeigt eine kontinuierliche Änderung der Verzögerungszeit Δt über der relativen Akkumulatorspannung U/Uₘₐₓ. Der Verlauf 14 zeigt in einem Bereich von 100 % bis 65 % der maximalen Akkumulatorspannung Uₘₐₓ eine konstant gewählte Verzögerungszeit Δt, die der maximalen Verzögerungszeit Δtₘ entspricht. In einem Spannungsbereich von 65 % bis 20 % der maximalen Akkumulatorspannung U_{maX} sinkt der Verlauf 14 mit der Akkumulatorspannung U linear bis Δt = 0 im Punkt Uₛ. Der Verlauf 15 ist gestrichelt dargestellt und zeigt in einem Spannungsbereich von 100 % bis 50 % eine konstante Verzögerungszeit Δt, die bei 50 % sprunghaft auf eine Verzögerungszeit von Δt= 0 absinkt. Der Kurvenverlauf 16 zeigt in einem Spannungsbereich von 100 % bis 65 % eine konstante Verzögerungszeit Δt, die der maximalen Verzögerungszeit Δtₘ entspricht. In einem Akkumulatorspannungsbereich von 65 bis 40 % sinkt der Verlauf 16 mit der Akkumulatorspannung U linear um bei 40% der maximalen Akkumulatorspannung sprunghaft auf eine Verzögerungszeit Δt gleich Null zu sinken.

Zusätzlich zur Vorgabe der Verzögerungszeit Δt für die Ausschaltverzögerungsvorrichtung 3 kann die Tiefentladungsschutzvorrichtung auch Einschaltladungsschwellen zum Wiedereinschalten einzelner Komponenten der Elektrohandwerkzeugmaschine 1, wie zum Beispiel dem elektrischen Antrieb 6 und der elektrischen Einrichtung 7 vorgeben. Dabei sind die beschriebenen Ladungsschwellen (kritische Ladungsschwelle und Einschaltladungsschwellen, beziehungsweise deren entsprechende Spannungsschwellen) nicht notwendigerweise fest, sondern können in Abhängigkeit von mindestens einer Randbedingung - wie zum Beispiel einer Temperaturmessung in unmittelbarer Umgebung des Akkumulators - beeinflusst werden.

## Patentansprüche

1. Elektrohandwerkzeugmaschine mit mindestens einem elektrischen Antrieb, mindestens einer elektrischen, für ihre Funktion elektrische Energie benötigenden Einrichtung, einer Ausschaltverzögerungsvorrichtung für den elektrischen Antrieb und/oder die elektrische Einrichtung und mit mindestens einem Akkumulator für die elektrische Versorgung des Antriebs und der elektrischen Einrichtung, einer Tiefentladungsschutzvorrichtung (8), **dadurch gekennzeichnet, dass** die Tiefentladungsschutzvorrichtung in Abhängigkeit von dem durch sie erfassten Ladezustand des Akkumulators (9) die Verzögerungszeit (Δt) der Ausschaltverzögerungsvorrichtung (3) vorgibt.

2. Elektrohandwerkzeugmaschine nach Anspruch 1, **dadurch gekennzeichnet, dass** die Ausschaltverzögerungsvorrichtung (3) die Tiefentladungsschutzvorrichtung (8) aufweist.

3. Elektrohandwerkzeugmaschine nach einem der vorhergehenden Ansprüche, **dadurch gekennzeichnet, dass** die Tiefentladungsschutzvorrichtung (8) bei geringerem Ladezustand des Akkumulators (9) eine geringere Verzögerungszeit (Δt) der Ausschaltverzögerungsvorrichtung (3) vorgibt.

4. Elektrohandwerkzeugmaschine nach einem der vorhergehenden Ansprüche, **dadurch gekennzeichnet, dass** die Ausschaltverzögerungsvorrichtung (3) bei einem Ladezustand des Akkumulators (9) unterhalb einer kritischen Ladungsschwelle keine Ausschaltverzögerung vorsieht.

5. Verfahren zum Betrieb einer Elektrohandwerkzeugmaschine mit mindestens einem elektrischen Antrieb, mindestens einer elektrischen, für ihre Funktion elektrische Energie benötigenden Einrichtung, einer Ausschaltverzögerungsvorrichtung für den elektrischen Antrieb und/oder die elektrische Einrichtung und mit mindestens einem Akkumulator für die elektrische Versorgung des Antriebs und der elektrischen Einrichtung, **dadurch gekennzeichnet, dass** eine Tiefentladungsschutzvorrichtung der Elektrohandwerkzeugmaschine den Ladezustand des Akkumulators erfasst und in Abhängigkeit von diesem Ladezustand eine Verzögerungszeit vorgibt, mit der die elektrische Einrichtung durch die Ausschaltverzögerungsvorrichtung verzögert abgeschaltet wird.

6. Verfahren nach Anspruch 5, **dadurch gekennzeichnet, dass** die Tiefentladungsschutzvorrichtung bei geringerem Ladezustand des Akkumulators eine geringere Verzögerungszeit der Ausschaltverzögerungsvorrichtung vorgibt.

7. Verfahren nach einem der vorhergehenden Ansprüche, **dadurch gekennzeichnet, dass** die Ausschaltverzögerungsvorrichtung die elektrische Einrichtung bei einem Ladezustand des Akkumulators unterhalb einer kritischen Ladungsschwelle ohne Ausschaltverzögerung abschaltet.

8. Verfahren nach einem der vorhergehenden Ansprüche, **dadurch gekennzeichnet, dass** die Verzögerungszeit nur vorbestimmte Werte annehmen kann.

9. Verfahren nach einem der vorhergehenden Ansprüche, **dadurch gekennzeichnet, dass** die Tiefentladungsschutzvorrichtung die Verzögerungszeit mit dem Ladezustand des Akkumulators bis zum Erreichen der kritischen Ladungsschwelle kontinuierlich geändert vorgibt.

10. Verfahren nach einem der vorhergehenden Ansprüche, **dadurch gekennzeichnet, dass** die Tiefentladungsschutzvorrichtung die Verzögerungszeit mit dem Ladezustand des Akkumulators schrittweise geändert vorgibt.

11. Verfahren nach einem der vorhergehenden Ansprüche, **dadurch gekennzeichnet, dass** die Tiefentladungsschutzvorrichtung den Ladezustand des Akkumulators durch Ermittlung der Akkumulatorspannung bestimmt.

12. Verfahren nach einem der vorhergehenden Ansprüche, **dadurch gekennzeichnet, dass** die Akkumulatorspannung zusammen mit einem entsprechenden Strom bei elektrischer Belastung gemessen wird.

13. Verfahren nach einem der vorhergehenden Ansprüche, **dadurch gekennzeichnet, dass** die Akkumulatorspannung quasi-stromfrei gemessen wird.

14. Verfahren nach einem der vorhergehenden Ansprüche, **dadurch gekennzeichnet, dass** die Tiefentladungsschutzvorrichtung ein Einschalten des elektrischen Antriebs nur bei einem Ladezustand des Akkumulators oberhalb einer Antriebs-Einschaltladungsschwelle ermöglicht.

15. Verfahren nach einem der vorhergehenden Ansprüche, **dadurch gekennzeichnet, dass** die Tiefentladungsschutzvorrichtung ein Einschalten der elektrischen Einrichtung nur bei einem Ladezustand des Akkumulators oberhalb einer Einrichtungs-Einschaltladungsschwelle ermöglicht.

## Claims

1. Electrical handheld machine tool having at least one electrical drive, at least one electrical device which requires electrical energy to operate, a switch-off delay apparatus for the electrical drive and/or the electrical device, and having at least one rechargeable battery for supplying electrical power to the drive and the electrical device, and having a deep discharge protection apparatus (8), **characterized in that** the deep discharge protection apparatus prespecifies the delay time (Δt) of the switch-off delay apparatus (3) as a function of the charge state of the rechargeable battery (9) detected by the said deep discharge protection apparatus.

2. Electrical handheld machine tool according to Claim 1, **characterized in that** the switch-off delay apparatus (3) has the deep discharge protection apparatus (8).

3. Electrical handheld machine tool according to either of the preceding claims, **characterized in that** the deep discharge protection apparatus (8) prespecifies a shorter delay time (Δt) of the switch-off delay apparatus (3) at a relatively low charge state of the rechargeable battery (9).

4. Electrical handheld machine tool according to one of the preceding claims, **characterized in that** the switch-off delay apparatus (3) does not provide a switch-off delay operation at a charge state of the rechargeable battery (9) below a critical charge threshold.

5. Method for operating an electrical handheld machine tool having at least one electrical drive, at least one electrical device which requires electrical energy to operate, a switch-off delay apparatus for the electrical drive and/or the electrical device, and having at least one rechargeable battery for supplying electrical power to the drive and the electrical device, **characterized in that** a deep discharge protection apparatus of the electrical handheld machine tool detects the charge state of the rechargeable battery and, as a function of this charge state, prespecifies a delay time with which the electrical device will be switched off with a delay by the switch-off delay apparatus.

6. Method according to Claim 5, **characterized in that** the deep discharge protection apparatus prespecifies a shorter delay time of the switch-off delay apparatus at a relatively low charge state of the rechargeable battery.

7. Method according to one of the preceding claims, **characterized in that** the switch-off delay apparatus switches off the electrical device at a charge state of the rechargeable battery below a critical charge threshold without a switch-off delay operation.

8. Method according to one of the preceding claims, **characterized in that** the delay time can assume only predetermined values.

9. Method according to one of the preceding claims, **characterized in that** the deep discharge protection apparatus prespecifies the delay time in a manner continuously changing with the charge state of the rechargeable battery until the critical charge threshold is reached.

10. Method according to one of the preceding claims, **characterized in that** the deep discharge protection apparatus prespecifies the delay time in a manner changing in steps with the charge state of the rechargeable battery.

11. Method according to one of the preceding claims, **characterized in that** the deep discharge protection apparatus determines the charge state of the rechargeable battery by determining the voltage of the rechargeable battery.

12. Method according to one of the preceding claims, **characterized in that** the voltage of the rechargeable battery is measured together with a corresponding current in the event of electrical loading.

13. Method according to one of the preceding claims, **characterized in that** the voltage of the rechargeable battery is measured in a manner virtually free from current.

14. Method according to one of the preceding claims, **characterized in that** the deep discharge protection apparatus allows the electrical drive to be switched on only at a charge state of the rechargeable battery above a drive switch-on charge threshold.

15. Method according to one of the preceding claims, **characterized in that** the deep discharge protection apparatus allows the electrical device to be switched on only at a charge state of the rechargeable battery above a device switch-on charge threshold.

## Revendications

1. Outil électrique manuel qui présente au moins un entraînement électrique,
au moins un dispositif électrique qui a besoin d'énergie électrique pour remplir sa fonction,
un dispositif de retardement du débranchement de l'entraînement électrique et/ou du dispositif électrique,
au moins un accumulateur qui assure l'alimentation électrique de l'entraînement et du dispositif électrique
et un dispositif (8) de protection contre les fortes décharges,
**caractérisé en ce que**
le dispositif de protection contre les fortes décharges définit la durée (Δt) du retard du dispositif (3) de retardement du débranchement en fonction de l'état de charge qu'il a détecté sur l'accumulateur (9).

2. Outil électrique manuel selon la revendication 1, **caractérisé en ce que** le dispositif (3) de retardement du débranchement présente le dispositif (8) de protection contre les fortes décharges.

3. Outil électrique manuel selon l'une des revendications précédentes, **caractérisé en ce que** le dispositif (8) de protection contre les fortes décharges définit une durée de retard (Δt) plus courte du dispositif (3) de retardement du débranchement lorsque l'état de charge de l'accumulateur (9) est bas.

4. Outil électrique manuel selon l'une des revendications précédentes, **caractérisé en ce que** le dispositif (3) de retardement du débranchement ne prévoit pas de retard de débranchement lorsque l'état de charge de l'accumulateur (9) est situé en dessous d'un seuil de charge critique.

5. Procédé de fonctionnement d'un outil électrique manuel présentant
au moins un entraînement électrique,
au moins un dispositif électrique qui a besoin d'énergie électrique pour remplir sa fonction,
un dispositif de retardement du débranchement de l'entraînement électrique et/ou du dispositif électrique et
au moins un accumulateur qui assure l'alimentation électrique de l'entraînement et du dispositif électrique,
**caractérisé en ce que**
un dispositif de protection contre les fortes décharges de l'outil électrique manuel détecte l'état de charge de l'accumulateur et définit en fonction de cet état de charge la durée de laquelle le débranchement du dispositif électrique est retardé par le dispositif de retardement du débranchement.

6. Procédé selon la revendication 5, **caractérisé en ce que** le dispositif de protection contre les fortes décharges définit une durée de retard plus courte du dispositif de retardement du débranchement lorsque l'état de charge de l'accumulateur est bas.

7. Procédé selon l'une des revendications précédentes, **caractérisé en ce que** le dispositif de retardement du débranchement débranche le dispositif électrique sans retarder le débranchement lorsque l'état de charge de l'accumulateur est situé en dessous d'un seuil de charge critique.

8. Procédé selon l'une des revendications précédentes, **caractérisé en ce que** la durée du retard ne peut prendre que des valeurs prédéterminées.

9. Procédé selon l'une des revendications précédentes, **caractérisé en ce que** le dispositif de protection contre les fortes décharges définit la durée du retard de manière variable en continu selon l'état de charge de l'accumulateur jusqu'à atteindre le seuil de charge critique.

10. Procédé selon l'une des revendications précédentes, **caractérisé en ce que** le dispositif de protection contre les fortes décharges définit la durée du retard en la modifiant par pas selon l'état de charge de l'accumulateur.

11. Procédé selon l'une des revendications précédentes, **caractérisé en ce que** le dispositif de protection contre les fortes décharges définit l'état de charge de l'accumulateur en détectant la tension aux bornes de l'accumulateur.

12. Procédé selon l'une des revendications précédentes, **caractérisé en ce que** la tension aux bornes de l'accumulateur est mesurée en même temps que le courant électrique correspondant en cas de prélèvement d'énergie électrique.

13. Procédé selon l'une des revendications précédentes, **caractérisé en ce que** la tension aux bornes de l'accumulateur est mesurée quasiment sans courant.

14. Procédé selon l'une des revendications précédentes, **caractérisé en ce que** le dispositif de protection contre les fortes décharges permet de brancher l'entraînement électrique uniquement lorsque l'état de charge de l'accumulateur est situé au-dessus d'un seuil de charge qui permet le branchement de l'entraînement.

15. Procédé selon l'une des revendications précédentes, **caractérisé en ce que** le dispositif de protection contre les fortes décharges ne permet de brancher le dispositif électrique que lorsque l'état de charge de l'accumulateur est situé au-dessus d'un seuil de charge permettant le branchement du dispositif.
